# EUROPEAN PATENT APPLICATION

(11) **EP 4 697 137 A1**
(43) Date of publication of application: **18.02.2026**
(21) Application number: 25188104.1
(22) Date of filing: 08.07.2025
(51) Int. Cl.: G06F 1/18, G06F 1/20, H05K 7/20

(54) **AIRFLOW DISTRIBUTION TO COOL MEMORY MODULE SHADOWED BY THE PROCESSOR**

(30) Priority: 14.08.2024 US 202418805225
(71) Applicant: Intel Corporation, Santa Clara, CA 95054 (US)
(72) Inventor: MACDONALD, Mark, Beaverton, 97006 (US); HEYMANN, Douglas, Hillsboro, 97124 (US); LIMAYE, Ameya, Portland, 97229 (US); BEYER, Debra, Hillsboro, 97124 (US); KIM, Sung Ki, Portland, 97229 (US)
(74) Representative: Maiwald GmbH

(57) **Abstract**

A cooling system includes a cooling fluid bypass to direct cooling fluid around a processor device to a memory module shadowed by the processor device from the cooling fluid flow. The fluid bypass allows the system to direct cooling fluid to the shadowed memory module that has not been used to cool the processor. There are various configurations, allowing the bypassing of different amounts of cooling fluid, allowing system designers to balance a tradeoff between processor heat and memory module heat.

## Description

### FIELD

Descriptions are generally related to computer devices, and more particular descriptions are related to computer component cooling.

### BACKGROUND

Memory bandwidth is crucial to some server systems, especially Al (artificial intelligence) servers. The need for memory bandwidth creates physical constraints on the memory module layout around the processor to improve signal integrity, and the physical layout constraint reduces the maximum cooling effect.

The physical layout results in leading memory modules preheating the airflow to the other memory modules. The physical layout also results in trailing memory modules that experience significant heating. The heating of the downstream modules limits the memory bandwidth, which ultimately limits system memory bandwidth with significant negative impact on Al systems and workloads.

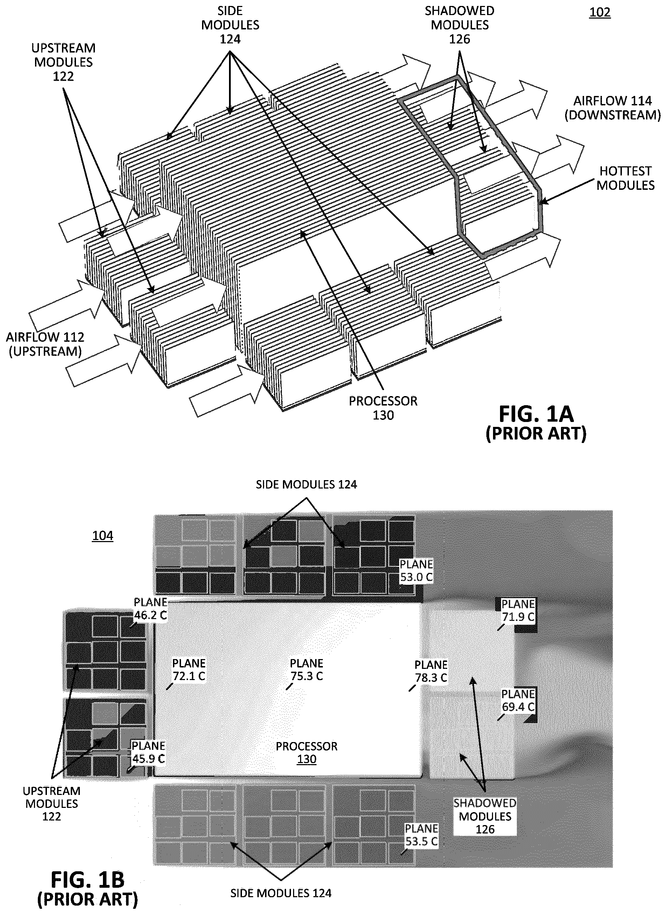

**Figure 1A** is a diagram of a prior art cooling system. System 102 illustrates a cooling system. System 102 illustrates the airflow for the cooling. Airflow 112 represents the upstream airflow that flows to airflow 114, which represents the downstream airflow.

System 102 has heatsinks on upstream modules 122, which is upstream relative to processor 130. Side modules 124 are to the side of processor 130. Airflow 112 passes over upstream modules 122 to processor 130, and airflow 112 passes over side modules 124 without first passing over upstream modules 122 and to the side of processor 130. System 102 has shadowed module 126, which are the hottest modules. The temperature of shadowed modules 126 limits the system bandwidth.

**Figure 1B** is a diagram of a heat map for a prior art cooling system. Diagram 104 illustrates an example of simulated temperatures for system 102. Upstream modules 122 are illustrated with temperatures of 46.2 C and 45.9 C. Side modules 124 are illustrated with temperatures of 53.0 C and 53.5 C. Processor 130 is illustrated with a temperature of 72.1 C at the upstream portion, 75.3 C at the middle portion, and 78.3 C at the downstream portion.

Shadowed modules 126 are illustrated with temperatures of 71.9 C and 69.4 C, representing a temperature differential of approximately 25 C between the upstream and downstream memory modules.

The way memory is randomly permuted among the channels, if just one channel reaches its temperature limit and throttling is necessary, the system will throttle the other memory channels as well. The memory controller cannot redirect memory traffic to cooler DRAM (dynamic random access memory) modules. The temperature differential results in hottest channels limiting the entire system. The significant temperature differential indicates that shadowed modules 126 can limit the system memory bandwidth.

### BRIEF DESCRIPTION OF THE DRAWINGS

The following description includes discussion of figures having illustrations given by way of example of an implementation. The drawings should be understood by way of example, and not by way of limitation. As used herein, references to one or more examples are to be understood as describing a particular feature, structure, or characteristic included in at least one implementation of the invention. Phrases such as "in one example" or "in an alternative example" appearing herein provide examples of implementations of the invention, and do not necessarily all refer to the same implementation. However, they are also not necessarily mutually exclusive.
**Figure 1A** is a diagram of a prior art cooling system.
**Figure 1B** is a diagram of a heat map for a prior art cooling system.
**Figure 2A** is a diagram of a cooling system with a cooling bypass path.
**Figure 2B** is a diagram of a cooling system with a cooling bypass path with airflow mixing.
**Figure 3** is a diagram of a cooling system with a processor hot airflow bypass.
**Figure 4A** is a diagram of a cooling system with a cooling bypass path with parallel airflow paths.
**Figure 4B** is a diagram of a heat map for a cooling system with a cooling bypass path.
**Figure 5A** is a diagram of a cooling bypass with staggered fins.
**Figure 5B** is a diagram of a cooling bypass with airflow baffles.
**Figure 5C** is a diagram of a cooling bypass with curved fins.
**Figure 6A** is a diagram of a bidirectional heatsink with stacked, orthogonal fins.
**Figure 6B** is a diagram of a bidirectional heatsink with pin fins.
**Figure 6C** is a diagram of a bidirectional heatsink with bidirectional material.
**Figure 7** is a block diagram of an example of a memory subsystem in a cooling system with a cooling bypass path can be implemented.
**Figures 8A-8B** are block diagrams of an example of a CAMM system in which a cooling system with a cooling bypass path can be implemented.
**Figure 9** is a block diagram of an example of a computing system in which a cooling system with a cooling bypass path can be implemented.
**Figure 10** is a block diagram of an example of a multi-node network in which a cooling system with a cooling bypass path can be implemented.

Descriptions of certain details and implementations follow, including non-limiting descriptions of the figures, which may depict some or all examples, and well as other potential implementations.

### DETAILED DESCRIPTION

As described herein, a cooling system includes a cooling fluid bypass to direct cooling fluid around a processor device to a memory module shadowed by the processor device from the cooling fluid flow. The fluid bypass allows the system to direct cooling fluid to the shadowed memory module that has not been used to cool the processor. There are various configurations, allowing the bypassing of different amounts of cooling fluid, allowing system designers to balance a tradeoff between processor heat and memory module heat.

In a system with memory modules surrounding a processor, the cooling system redirects cool fluid around the processor to the hottest memory modules. The hottest modules are the ones downstream from the processor. The cooling system described herein applies to cooling with a fluid. In one example, the cooling fluid is a liquid, such as water. In one example, the cooling fluid is air. In one example, the cooling fluid is a gas other than air. For purposes of simplicity, the descriptions below generally refer to air cooling and airflow. It will be understood that the descriptions apply to airflow and other types of cooling fluid.

In one example, the cooling system redirects airflow to achieve better memory cooling. The system design includes ducting that allows cold fluid to reach downstream modules without first being used to cool the processor. An application of the cooling system delivers cold air to heatsinks downstream from the processor for CAMMs (compression attached memory modules) shadowed by the processor. The CAMMs include multiple DRAM (dynamic random access memory) devices.

Simulations have illustrated that airflow distribution in accordance with an example of the cooling system described can yield an additional 32W of cooling capability per module. In an environment where the upper limit of bandwidth is limited by the cooling capacity at 1x refresh (e.g., an 85 C DRAM temperature limit), the additional cooling capacity can yield an additional 2TB/s of bandwidth per platform.

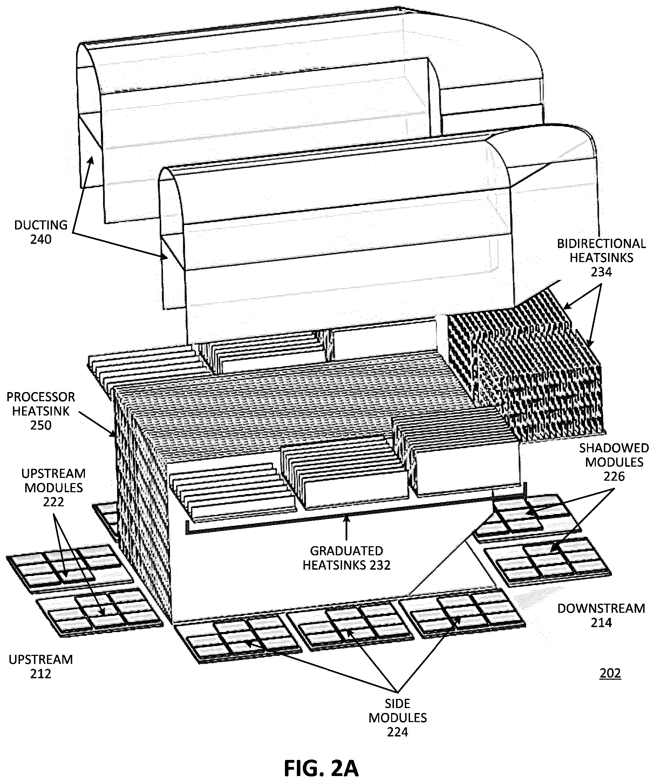

**Figure 2A** is a diagram of a cooling system with a cooling bypass path. System 202 illustrates a system with a processor surrounded by memory modules. The processor is not specifically identified in system 202, as it is below processor heatsink 250. Upstream 212 represents a place where the cooling airflow first interacts with system 202, and downstream 214 indicates the direction of the airflow.

System 202 illustrates upstream modules 222, side modules 224, and shadowed modules 226, which surround the processor. While not labeled, it will be understood that there can be side modules on the other side of the processor that are not visible in system 202. Upstream modules 222 represent modules upstream from, or upstream with respect to, the processor with respect to the flow of the cooling fluid, such as the airflow. Shadowed modules 226 represent modules downstream from, or downstream with respect to, the processor with respect to the airflow. Without redirecting the cooling airflow, shadowed modules 226 would only be cooled by air that has already been heated up by the processor.

Side modules 224 represent modules to the side of the processor, relative to the airflow. Thus, the airflow can pass over the processor and side modules 224 in parallel. The airflow will pass over upstream modules 222 before passing over the processor. The airflow will pass over the processor before passing over shadowed modules 226, except as described in various implementations to redirect cooling fluid to shadowed modules 226.

Processor heatsink 250 represents a heatsink over the processor. Side modules 224 and shadowed modules 226 have heatsinks over them, typically one heatsink per memory module. In one example, upstream modules 222 have heatsinks over them, which can be one heatsink per upstream memory module. In one example, upstream modules 222 do not have heatsinks on them (as illustrated in system 202). In one example, upstream modules 222 have minimal heatsinks on them, with vertical heights as low as or lower than the vertical heights of the shortest heatsinks of system 202.

In one example, as illustrated, system 202 has graduated heatsinks 232. Graduated heatsinks 232 have gradually increasing height in the downstream direction of the airflow. Graduated heatsinks 232 can minimize the pre-heating of the air from upstream modules to downstream modules. Thus, the cooling effect is less on upstream modules, and greater on downstream, balancing out the cooling effect on the memory modules.

Thus, the side memory module further upstream has a heatsink with a lower vertical height than the side memory module further downstream. In one example, the heatsink graduation continues to bidirectional heatsinks 234 over shadowed modules 226, where the heatsinks with the greatest vertical height are over the memory modules furthest downstream. Thus, bidirectional heatsinks 234 can have a vertical height greater than the side memory module heatsink with the greatest height.

As illustrated, in one example, the heatsinks on shadowed modules 226 are bidirectional. Bidirectional heatsinks 234 allow airflow to pass in both the x-axis direction and the y-axis direction with respect to the plane on which the memory modules are mounted. The processor and the memory modules are mounted on a common PCB (printed circuit board) or system board (which can be a PCB or other type of board).

In one example, system 202 includes ducting 240 to direct cool airflow to bidirectional heatsinks 234 of shadowed modules 226. In one example, ducting 240 covers side modules 224 without covering the processor. More specifically, ducting 240 can cover graduated heatsinks 232 over side modules 224, directing airflow over the heatsinks over the side memory modules, without covering processor heatsink 250. It will be understood that processor heatsink 250 has a greater vertical height than any of the heatsinks over side modules 224. Thus, ducting 240 can capture the empty space adjacent the processor by creating a cooling airflow bypass in the space that is typically empty.

Ducting 240 directs cooling airflow around processor heatsink 250 to bidirectional heatsinks 234, to cool shadowed modules 226 with airflow that has not been used to cool the processor. In one example, ducting 240 includes a primary chamber that directs airflow over graduated heatsinks 232 and then to bidirectional heatsinks 234. In one example, ducting 240 includes a bypass chamber that directs airflow over graduated heatsinks 232, bypassing graduated heatsinks, and can thus direct cooling airflow to bidirectional heatsinks 234 without having first been used to cool the processor or side modules 224.

Referring back to system 102, the heatsinks for side modules 124 typically have the same vertical height, and the fins on the heatsinks have the same pitch, referring to the lateral distance between adjacent fins. In one example, graduated heatsinks 232 have the same pitch. In one example, as illustrated, graduated heatsinks have decreasing pitch with increasing vertical height. Thus, of graduated heatsinks 232, the heatsink furthest upstream has the lowest vertical height and has the greatest pitch, with greater lateral distance between adjacent fins. The heatsink furthest downstream of graduated heatsinks 232 has the highest vertical height and the smallest pitch, with less lateral distance between adjacent fins.

In one example, the processor of system 202 is a CPU (central processing unit). In one example, the processor of system 202 is a GPU (graphics processing unit). The memory modules typically include DRAM (dynamic random access memory) devices. In one example, the memory devices are DDR (double data rate) memory devices.

In one example, the memory modules are CAMMs (compression attached memory modules). Alternatively, other memory module types can be used. In one example, the memory modules are DDR5 (DDR version 5) memory modules. In one example, the memory modules are LPDDR6 (low power DDR version 6) memory modules.

The cooling system of system 202 can improve the memory bandwidth of system 202. Memory modules benefit from being placed close to the processor for maximum signal integrity. "Close" placement can be approximately 60 mm for DDR modules, and approximately 30 mm for LPDDR modules. At 30 mm, the memory channel length is only slightly longer than the width of a CAMM module.

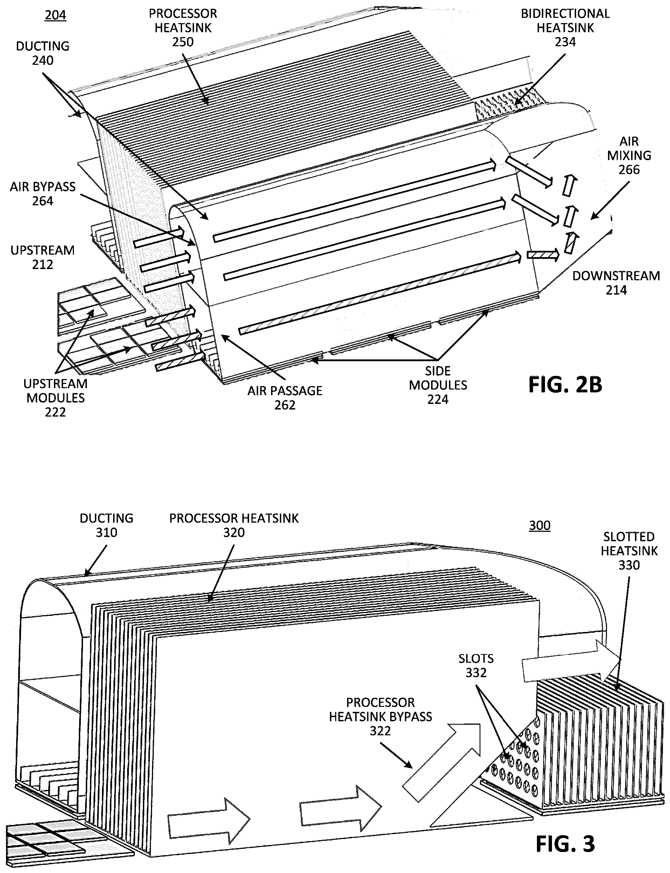

**Figure 2B** is a diagram of a cooling system with a cooling bypass path with airflow mixing. System 204 illustrates a system in accordance with an example of system 202. System 204 more specifically illustrates ducting 240 mounted over side modules 224, next to processor heatsink 250. Ducting 240 provides a bypass path for the cooling fluid around the processor, allowing cool airflow to reach bidirectional heatsink 234 without first being used to cool the processor.

System 204 illustrates upstream 212 and downstream 214 to indicate the direction of airflow. In one example, upstream modules 222 do not have any heatsink, as the cooling fluid can pass directly over the modules and cool them sufficiently without the need for a heatsink. Alternatively, a heatsink can be placed over upstream modules 222. In one example, the heatsinks over the memory modules are graduated all the way from upstream modules to the downstream modules, gradually increasing in vertical height in the direction of the airflow.

In one example, ducting 240 includes air passage 262, which passes directly over the heatsinks of side modules 224. In one example, ducting 240 includes air bypass 264, which is a separate air passage from air passage 262. More specifically, air bypass 264 passes over the heatsinks of side modules 224, separated by a structure in ducting 240. Thus, air bypass 264 does not directly pass over the heatsinks of side modules 224, allowing cool air to pass directly to bidirectional heatsink 234.

In one example, ducting 240 is open at the end of air passage 262 and air bypass 264, allowing the cooler air stream (the bypass airflow that has not cooled the side memory modules) and the warmer air stream (the airflow used to cool the side memory modules) to mix, as illustrated by air mixing 266. With air mixing 266, the warmer air stream and the cooler air stream are mixed into one plenum, which is redirected to the downstream memory modules. With air mixing 266, system 204 illustrates an example of "serial flow distribution" of the cooling fluid. Ducting 240 directs the mixed air stream to bidirectional heatsink 234 to cool the downstream memory modules.

It will be observed that ducting 240 directs airflow over side modules 224, from the side of bidirectional heatsink 234, and directs airflow through air bypass 264, from above bidirectional heatsink 234. It will be understood that air passage 262 bypasses processor heatsink 250, and air bypass 264 bypasses both processor heatsink 250 and the heatsinks of side modules 224.

**Figure 3** is a diagram of a cooling system with a processor hot airflow bypass. System 300 illustrates a system in accordance with an example of system 202. System 300 does not specifically indicate the details of the processor and memory modules; however, system 300 is an example of a system with a processor surrounded by memory modules.

System 300 illustrates processor heatsink 320 over the processor device. Ducting 310 represents a cooling fluid bypass around the processor to the downstream memory modules. System 300 illustrates an example of a processor exhaust bypass. Processor heatsink bypass 322 illustrates an airflow that goes through processor heatsink 320, over the processor, where the heatsink includes a structure to redirect the airflow over the processor above the heatsink of the downstream memory module. Processor heatsink bypass 322 provides a bypass mechanism to direct cooling fluid used to cool the processor over slotted heatsink 330.

It will be understood that by redirecting the processor exhaust over the downstream memory module, the heated air from the processor will not be used directly to cool the downstream memory modules. Instead of the airflow over the processor directly passing through the downstream memory module, only the airflow bypass through ducting 310 passes directly over the downstream memory module heatsink.

System 300 illustrates the heatsink of the downstream memory modules as slotted heatsink 330. Slotted heatsink 330 is an example of a bidirectional heatsink. Slotted heatsink 330 includes vertical, parallel fins with slots 332. Slots 332 are illustrated in system 300 as being round or elliptical in shape. Slots 332 can be generally rectangular or square. In one example, slotted heatsink 330 has parallel fins that are orthogonal to the direction of the airflow, with slots 332 to allow the airflow in the downstream direction. In such an example, the parallel fins allow airflow from the bypass of ducting 310.

In one example, slotted heatsink 330 has parallel fins that are parallel to the direction of the airflow to allow the airflow in the downstream direction. In such an example, slots 332 would allow airflow from the bypass of ducting 310. Thus, the series of slotted fins of slotted heatsink 330 can be parallel to the downstream airflow, or can be orthogonal to the downstream airflow, with the slots allowing airflow in the other direction.

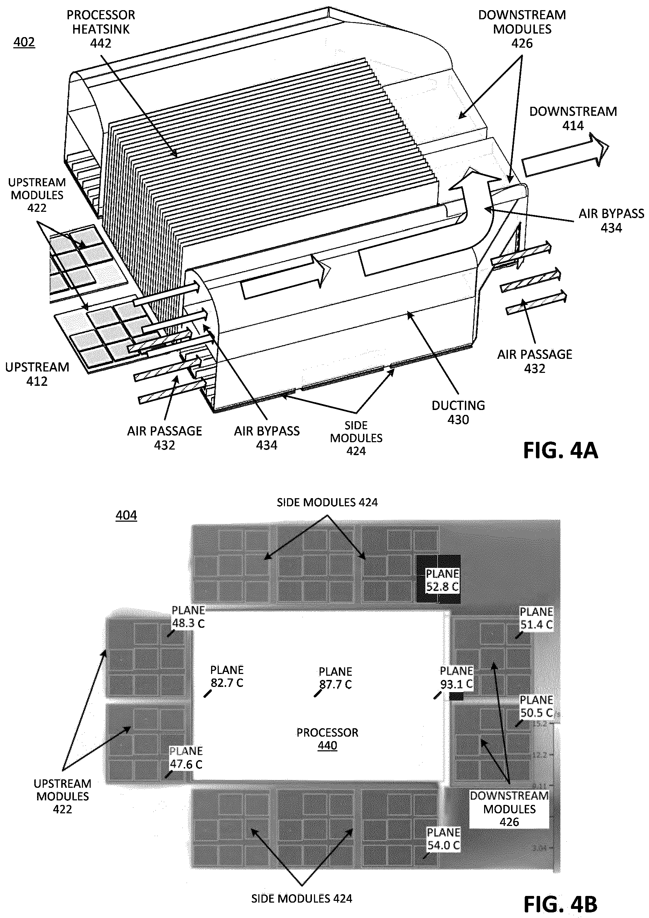

**Figure 4A** is a diagram of a cooling system with a cooling bypass path with parallel airflow paths. System 402 illustrates a system in accordance with an example of system 202. System 402 illustrates ducting 430 without air stream mixing, in contrast to what is illustrated in system 204.

System 402 illustrates upstream 412 and downstream 414 to indicate the direction of airflow. In one example, upstream modules 422 do not have any heatsink, as the cooling fluid can pass directly over the modules and cool them sufficiently without the need for a heatsink. Alternatively, a heatsink can be placed over upstream modules 422. In one example, the heatsinks over the memory modules are graduated all the way from upstream modules to the downstream modules, gradually increasing in vertical height in the direction of the airflow.

System 402 includes side modules 424 to the side of processor 440. Processor 440 represents the processor for which the memory modules provide system memory. System 402 illustrates downstream modules 426, which represent the memory modules downstream from processor 440, which are "shadowed" from the cooling fluid by being downstream from the processor.

System 402 illustrates ducting 430 to bypass airflow around processor 440 to downstream modules 426. In one example, ducting 430 includes air passage 432, which passes directly over the heatsinks of side modules 424. In one example, ducting 430 includes air bypass 434, which is a separate air passage from air passage 432. More specifically, air bypass 434 passes over the heatsinks of side modules 424, separated by a structure in ducting 430. Thus, air bypass 434 represents a bypass chamber that does not directly pass over the heatsinks of side modules 424, allowing cool air to pass directly to downstream modules 426.

In one example, ducting 430 is open at the end of air passage 432, allowing air passage 432 to exhaust to the side of upstream modules 426, without passing the airflow used to cool side modules 424 to cool downstream modules 426. In one example, the airflow over processor 440 is also bypassed over downstream modules 426, in accordance with an example of system 300.

System 402 illustrates a system having separate exit plenums for air passage 432 and air bypass 434. With the separate air exits from ducting 430, there is no air mixing between the air stream of air passage 432 and the air stream of air bypass 434. Without air mixing, system 402 illustrates an example of "parallel flow distribution" of the cooling fluid. Ducting 430 redirects cool airflow directly onto downstream modules 426 without being used to cool side modules 424 or processor 440.

**Figure 4B** is a diagram of a heat map for a cooling system with a cooling bypass path. Diagram 404 illustrates an example of simulated temperatures for system 402. More specifically, the temperatures are for a parallel flow distribution system.

Upstream modules 422 are illustrated with temperatures of 48.3 C and 47.6 C. Side modules 424 are illustrated with temperatures of 52.8 C and 54.0 C. Processor 440 is illustrated with a temperature of 82.7 C at the upstream portion, 87.7 C at the middle portion, and 93.1 C at the downstream portion. Downstream modules 426 are illustrated with temperatures of 51.4 C and 50.5 C, representing a temperature differential of approximately 3 C between the upstream and downstream memory modules.

The cooling simulation of diagram 404 is made under the same conditions as those of diagram 104 for prior art system 102. It will be observed that the temperature across the memory modules is nearly uniform in system 402. However, lowering the temperature of the memory modules can significantly increase the temperature in processor 440, which is approximately 10 C higher at the upstream portion, and 15 C at the downstream portion.

System 402 and the heat diagram of diagram 404 assume a processor exhaust bypass, which keeps the temperature of downstream modules 426 much lower, while significantly increasing the temperature of the processor. Thus, favoring memory module cooling over processor cooling results in a penalty to processor temperature performance.

It will be understood that different configurations can be used to achieve a different balance between the processor temperature and the memory module temperature. For example, a parallel flow distribution could be used without the processor exhaust bypass, which will lower the temperature of the processor at the expense of raising the temperature of downstream modules 426.

It can thus be understood that a system designer can design the cooling system with cooling capabilities matched to different processor configurations. For a processor that will execute workloads primarily constrained by memory bandwidth, more aggressive airflow bypass measures can be taken (such as those of system 402) to favor memory module temperature reduction over processor temperature. For a processor that will execute workloads that are more compute heavy, there can be less airflow bypass to the downstream modules. Such a configuration could still reduce the heat of the downstream modules to reduce the risk of memory overtemperature throttling, while still allowing primary cooling to the processor to reduce the risk of compute-intensive processor overheating. Thus, the system can allow a system designer to balance between memory bandwidth intensive workloads and computation intensive workloads.

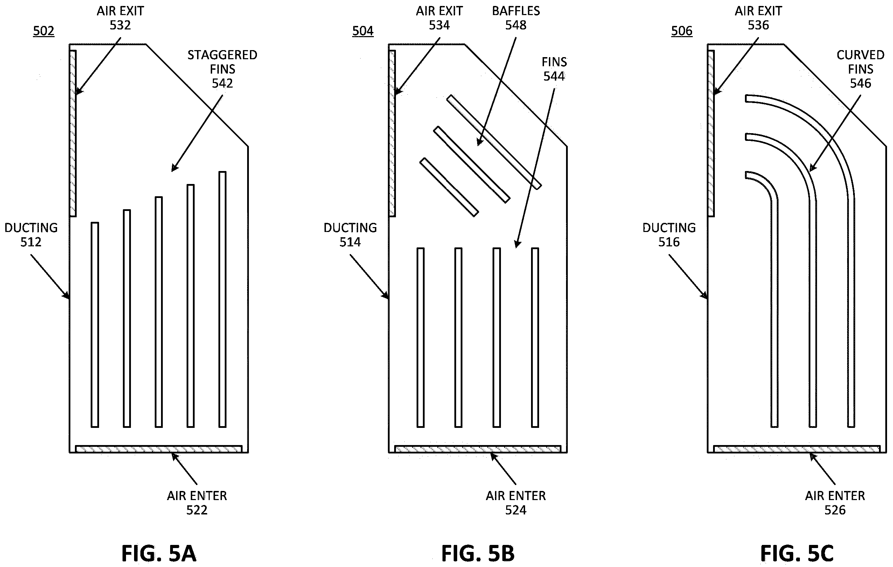

**Figure 5A** is a diagram of a cooling bypass with staggered fins. Diagram 502 represents a top view of ducting 512. Ducting 512 represents ducting in accordance with an example of ducting 240, ducting 310, or ducting 430. Diagram 502 indicates the direction of airflow through ducting 512 by air enter 522 and air exit 532. It will be understood that a mirror image ducting can be created to go over the other set of side modules.

Ducting 512 includes staggered fins 542, which represent vertical fins of the air bypass chamber to redirect the cooling fluid toward the downstream module. Staggered fins 542 have longer fins at the outside of the ducting, farther away from air exit 532, and shorter fins at the inside of the ducting, closer to air exit 532. Such a configuration will tend to cause the air to flow toward air exit 532. Staggered fins 542 thus tend to direct the cooling fluid to air exit 532, toward the downstream memory module.

**Figure 5B** is a diagram of a cooling bypass with airflow baffles. Diagram 504 represents a top view of ducting 514. Ducting 514 represents ducting in accordance with an example of ducting 240, ducting 310, or ducting 430. Diagram 504 indicates the direction of airflow through ducting 514 by air enter 524 and air exit 534. It will be understood that a mirror image ducting can be created to go over the other set of side modules.

Ducting 514 includes fins 544, which represent parallel vertical fins of the air bypass chamber, and baffles 548, which redirect the cooling fluid toward the downstream module. Fins 544 are illustrated as having the same length, although they could be staggered in accordance with an example of ducting 512. Ducting 514 specifically illustrates baffles 548, which are at an angle with respect to the direction of fluid flow through parallel fins 544. Such a configuration will tend to cause the air to flow toward air exit 534. Baffles 548 thus tend to direct the cooling fluid to air exit 534, toward the downstream memory module.

**Figure 5C** is a diagram of a cooling bypass with curved fins. Diagram 506 represents a top view of ducting 516. Ducting 516 represents ducting in accordance with an example of ducting 240, ducting 310, or ducting 430. Diagram 506 indicates the direction of airflow through ducting 512 by air enter 526 and air exit 536. It will be understood that a mirror image ducting can be created to go over the other set of side modules.

Ducting 516 includes curved fins 546, which represent curved vertical fins of the air bypass chamber to redirect the cooling fluid toward the downstream module. Curved fins 546 have curves at the end of the vertical fins. In one example, the curves of the outer fins, farther away from air exit 536, are longer than the curves of the inner fins, closer to air exit 536. Such a configuration will tend to cause the air to flow toward air exit 536. Curved fins 546 thus tend to direct the cooling fluid to air exit 536, toward the downstream memory module.

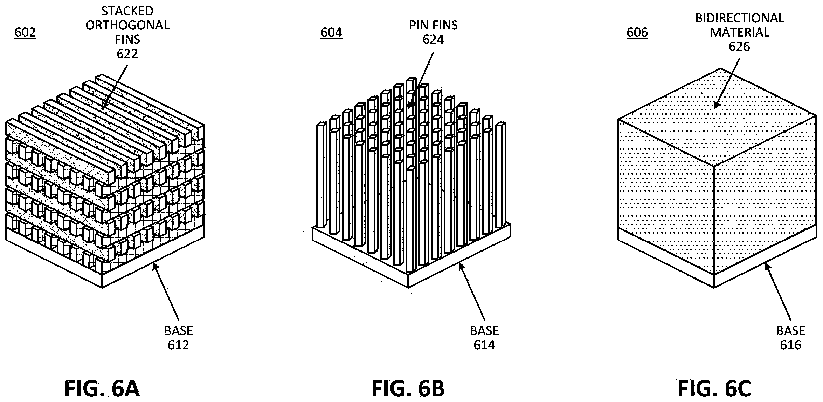

**Figure 6A** is a diagram of a bidirectional heatsink with stacked, orthogonal fins. Diagram 602 represents a bidirectional heatsink in accordance with an example of bidirectional heatsinks 234. More specifically, diagram 602 illustrates heatsink base 612 having a series of stacked orthogonal fins 622. The stacked orthogonal fins have one set of fins parallel to the downstream direction of the cooling fluid, and another set of fins stacked on top of it that is orthogonal to the downstream direction of the cooling fluid. Thus, the bidirectional heatsink can have a series of alternating, orthogonally stacked fins.

**Figure 6B** is a diagram of a bidirectional heatsink with pin fins. Diagram 604 represents a bidirectional heatsink in accordance with an example of bidirectional heatsinks 234. More specifically, diagram 604 illustrates heatsink base 614 having vertical pins, referred to as pin fins 624. Pin fins 624 are vertical pins that have a cross-section that can be rectangular, square, oval, round, or some other shape.

**Figure 6C** is a diagram of a bidirectional heatsink with bidirectional material. Diagram 606 represents a bidirectional heatsink in accordance with an example of bidirectional heatsinks 234. Diagram 606 illustrates heatsink base 616 having bidirectional material 626. Bidirectional material 626 can represent other type of structure that permits airflow orthogonal to the downstream direction of the cooling fluid as well as parallel to the downstream direction of the cooling fluid. For example, bidirectional material 626 can represent an amorphous solid material.

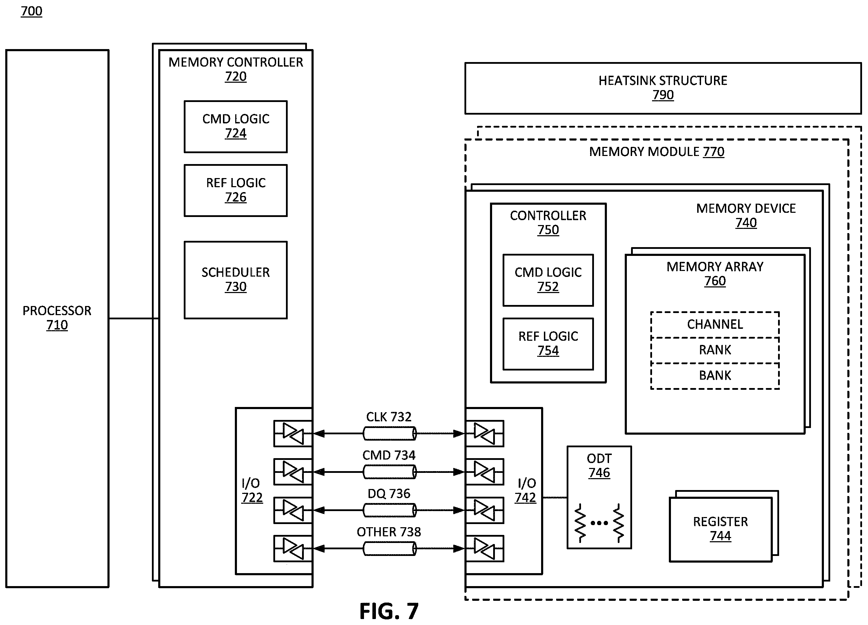

**Figure 7** is a block diagram of an example of a memory subsystem in a cooling system with a cooling bypass path can be implemented. System 700 includes a processor and elements of a memory subsystem in a computing device. System 700 is an example of a system in accordance with an example of system 202, system 300, or system 402.

In one example, system 700 includes heatsink structure 790 over memory modules 770. Heatsink structure 790 represents a cooling system structure to allow cooling fluid to bypass the processor device in accordance with any example herein.

Processor 710 represents a processing unit of a computing platform that may execute an operating system (OS) and applications, which can collectively be referred to as the host or the user of the memory. The OS and applications execute operations that result in memory accesses. Processor 710 can include one or more separate processors. Each separate processor can include a single processing unit, a multicore processing unit, or a combination. The processing unit can be a primary processor such as a CPU (central processing unit), a peripheral processor such as a GPU (graphics processing unit), or a combination. Memory accesses may also be initiated by devices such as a network controller or hard disk controller. Such devices can be integrated with the processor in some systems or attached to the processer via a bus (e.g., PCI express), or a combination. System 700 can be implemented as an SOC (system on a chip), or be implemented with standalone components.

Reference to memory devices can apply to different memory types. Memory devices often refers to volatile memory technologies. Volatile memory is memory whose state (and therefore the data stored on it) is indeterminate if power is interrupted to the device. Nonvolatile memory refers to memory whose state is determinate even if power is interrupted to the device. Dynamic volatile memory requires refreshing the data stored in the device to maintain state. One example of dynamic volatile memory includes DRAM (dynamic random-access memory), or some variant such as synchronous DRAM (SDRAM). A memory subsystem as described herein may be compatible with a number of memory technologies, such as DDR5 (double data rate version 5, JESD79-5, originally published by JEDEC in July 2020), LPDDR5 (LPDDR version 5, JESD209-5, originally published by JEDEC in February 2019), HBM2 (high bandwidth memory version 2, JESD235C, originally published by JEDEC in January 2020), HBM3 (HBM version 3, JESD238, originally published by JEDEC in January 2022), LPDDR6 (LPDDR version 6, JESD209-6, currently in discussion by JEDEC), DDR6 (DDR version 6, JESD79-6, currently in discussion by JEDEC), or others or combinations of memory technologies, and technologies based on derivatives or extensions of such specifications.

Memory controller 720 represents one or more memory controller circuits or devices for system 700. Memory controller 720 represents control logic that generates memory access commands in response to the execution of operations by processor 710. Memory controller 720 accesses one or more memory devices 740. Memory devices 740 can be DRAM devices in accordance with any referred to above. In one example, memory devices 740 are organized and managed as different channels, where each channel couples to buses and signal lines that couple to multiple memory devices in parallel. Each channel is independently operable. Thus, each channel is independently accessed and controlled, and the timing, data transfer, command and address exchanges, and other operations are separate for each channel. Coupling can refer to an electrical coupling, communicative coupling, physical coupling, or a combination of these. Physical coupling can include direct contact. Electrical coupling includes an interface or interconnection that allows electrical flow between components, or allows signaling between components, or both. Communicative coupling includes connections, including wired or wireless, that enable components to exchange data.

In one example, settings for each channel are controlled by separate mode registers or other register settings. In one example, each memory controller 720 manages a separate memory channel, although system 700 can be configured to have multiple channels managed by a single controller, or to have multiple controllers on a single channel. In one example, memory controller 720 is part of host processor 710, such as logic implemented on the same die or implemented in the same package space as the processor.

Memory controller 720 includes I/O interface logic 722 to couple to a memory bus, such as a memory channel as referred to above. I/O interface logic 722 (as well as I/O interface logic 742 of memory device 740) can include pins, pads, connectors, signal lines, traces, or wires, or other hardware to connect the devices, or a combination of these. I/O interface logic 722 can include a hardware interface. As illustrated, I/O interface logic 722 includes at least drivers/transceivers for signal lines. Commonly, wires within an integrated circuit interface couple with a pad, pin, or connector to interface signal lines or traces or other wires between devices. I/O interface logic 722 can include drivers, receivers, transceivers, or termination, or other circuitry or combinations of circuitry to exchange signals on the signal lines between the devices. The exchange of signals includes at least one of transmit or receive. While shown as coupling I/O 722 from memory controller 720 to I/O 742 of memory device 740, it will be understood that in an implementation of system 700 where groups of memory devices 740 are accessed in parallel, multiple memory devices can include I/O interfaces to the same interface of memory controller 720. In an implementation of system 700 including one or more memory modules 770, I/O 742 can include interface hardware of the memory module in addition to interface hardware on the memory device itself. Other memory controllers 720 will include separate interfaces to other memory devices 740.

The bus between memory controller 720 and memory devices 740 can be implemented as multiple signal lines coupling memory controller 720 to memory devices 740. The bus may typically include at least clock (CLK) 732, command/address (CMD) 734, and write data (DQ) and read data (DQ) 736, and zero or more other signal lines 738. In one example, a bus or connection between memory controller 720 and memory can be referred to as a memory bus. In one example, the memory bus is a multi-drop bus. The signal lines for CMD can be referred to as a "C/A bus" (or ADD/CMD bus, or some other designation indicating the transfer of commands (C or CMD) and address (A or ADD) information) and the signal lines for write and read DQ can be referred to as a "data bus." In one example, independent channels have different clock signals, C/A buses, data buses, and other signal lines. Thus, system 700 can be considered to have multiple "buses," in the sense that an independent interface path can be considered a separate bus. It will be understood that in addition to the lines explicitly shown, a bus can include at least one of strobe signaling lines, alert lines, auxiliary lines, or other signal lines, or a combination. It will also be understood that serial bus technologies can be used for the connection between memory controller 720 and memory devices 740. An example of a serial bus technology is 8B10B encoding and transmission of high-speed data with embedded clock over a single differential pair of signals in each direction. In one example, CMD 734 represents signal lines shared in parallel with multiple memory devices. In one example, multiple memory devices share encoding command signal lines of CMD 734, and each has a separate chip select (CS_n) signal line to select individual memory devices.

It will be understood that in the example of system 700, the bus between memory controller 720 and memory devices 740 includes a subsidiary command bus CMD 734 and a subsidiary bus to carry the write and read data, DQ 736. In one example, the data bus can include bidirectional lines for read data and for write/command data. In another example, the subsidiary bus DQ 736 can include unidirectional write signal lines for write and data from the host to memory, and can include unidirectional lines for read data from the memory to the host. In accordance with the chosen memory technology and system design, other signals 738 may accompany a bus or sub bus, such as strobe lines DQS. Based on design of system 700, or implementation if a design supports multiple implementations, the data bus can have more or less bandwidth per memory device 740. For example, the data bus can support memory devices that have either a x4 interface, a x8 interface, a x16 interface, or other interface. The convention "xW," where W is an integer that refers to an interface size or width of the interface of memory device 740, which represents a number of signal lines to exchange data with memory controller 720. The interface size of the memory devices is a controlling factor on how many memory devices can be used concurrently per channel in system 700 or coupled in parallel to the same signal lines. In one example, high bandwidth memory devices, wide interface devices, or stacked memory configurations, or combinations, can enable wider interfaces, such as a x128 interface, a x256 interface, a x512 interface, a x1024 interface, or other data bus interface width.

In one example, memory devices 740 and memory controller 720 exchange data over the data bus in a burst, or a sequence of consecutive data transfers. The burst corresponds to a number of transfer cycles, which is related to a bus frequency. In one example, the transfer cycle can be a whole clock cycle for transfers occurring on a same clock or strobe signal edge (e.g., on the rising edge). In one example, every clock cycle, referring to a cycle of the system clock, is separated into multiple unit intervals (Uls), where each UI is a transfer cycle. For example, double data rate transfers trigger on both edges of the clock signal (e.g., rising and falling). A burst can last for a configured number of Uls, which can be a configuration stored in a register, or triggered on the fly. For example, a sequence of eight consecutive transfer periods can be considered a burst length eight (BL8), and each memory device 740 can transfer data on each UI. Thus, a x8 memory device operating on BL8 can transfer 64 bits of data (8 data signal lines times 8 data bits transferred per line over the burst). It will be understood that this simple example is merely an illustration and is not limiting.

Memory devices 740 represent memory resources for system 700. In one example, each memory device 740 is a separate memory die. In one example, each memory device 740 can interface with multiple (e.g., 2) channels per device or die. Each memory device 740 includes I/O interface logic 742, which has a bandwidth determined by the implementation of the device (e.g., x16 or x8 or some other interface bandwidth). I/O interface logic 742 enables the memory devices to interface with memory controller 720. I/O interface logic 742 can include a hardware interface, and can be in accordance with I/O 722 of memory controller, but at the memory device end. In one example, multiple memory devices 740 are connected in parallel to the same command and data buses. In another example, multiple memory devices 740 are connected in parallel to the same command bus, and are connected to different data buses. For example, system 700 can be configured with multiple memory devices 740 coupled in parallel, with each memory device responding to a command, and accessing memory resources 760 internal to each. For a Write operation, an individual memory device 740 can write a portion of the overall data word, and for a Read operation, an individual memory device 740 can fetch a portion of the overall data word. The remaining bits of the word will be provided or received by other memory devices in parallel.

In one example, memory devices 740 are disposed directly on a motherboard or host system platform (e.g., a PCB (printed circuit board) or substrate on which processor 710 is disposed) of a computing device. In one example, memory devices 740 can be organized into memory modules 770. In one example, memory modules 770 represent dual inline memory modules (DIMMs). In one example, memory modules 770 represent other organization of multiple memory devices to share at least a portion of access or control circuitry, which can be a separate circuit, a separate device, or a separate board from the host system platform. Memory modules 770 can include multiple memory devices 740, and the memory modules can include support for multiple separate channels to the included memory devices disposed on them. In another example, memory devices 740 may be incorporated into the same package as memory controller 720, such as by techniques such as multi-chip-module (MCM), package-on-package, through-silicon via (TSV), or other techniques or combinations. Similarly, in one example, multiple memory devices 740 may be incorporated into memory modules 770, which themselves may be incorporated into the same package as memory controller 720. It will be appreciated that for these and other implementations, memory controller 720 may be part of host processor 710.

Memory devices 740 each include one or more memory arrays 760. Memory array 760 represents addressable memory locations or storage locations for data. Typically, memory array 760 is managed as rows of data, accessed via wordline (rows) and bitline (individual bits within a row) control. Memory array 760 can be organized as separate channels, ranks, and banks of memory. Channels may refer to independent control paths to storage locations within memory devices 740. Ranks may refer to common locations across multiple memory devices (e.g., same row addresses within different devices) in parallel. Banks may refer to sub-arrays of memory locations within a memory device 740. In one example, banks of memory are divided into sub-banks with at least a portion of shared circuitry (e.g., drivers, signal lines, control logic) for the sub-banks, allowing separate addressing and access. It will be understood that channels, ranks, banks, sub-banks, bank groups, or other organizations of the memory locations, and combinations of the organizations, can overlap in their application to physical resources. For example, the same physical memory locations can be accessed over a specific channel as a specific bank, which can also belong to a rank. Thus, the organization of memory resources will be understood in an inclusive, rather than exclusive, manner.

In one example, memory devices 740 include one or more registers 744. Register 744 represents one or more storage devices or storage locations that provide configuration or settings for the operation of the memory device. In one example, register 744 can provide a storage location for memory device 740 to store data for access by memory controller 720 as part of a control or management operation. In one example, register 744 includes one or more Mode Registers. In one example, register 744 includes one or more multipurpose registers. The configuration of locations within register 744 can configure memory device 740 to operate in different "modes," where command information can trigger different operations within memory device 740 based on the mode. Additionally or in the alternative, different modes can also trigger different operation from address information or other signal lines depending on the mode. Settings of register 744 can indicate configuration for I/O settings (e.g., timing, termination or ODT (on-die termination) 746, driver configuration, or other I/O settings).

In one example, memory device 740 includes ODT 746 as part of the interface hardware associated with I/O 742. ODT 746 can be configured as mentioned above, and provide settings for impedance to be applied to the interface to specified signal lines. In one example, ODT 746 is applied to DQ signal lines. In one example, ODT 746 is applied to command signal lines. In one example, ODT 746 is applied to address signal lines. In one example, ODT 746 can be applied to any combination of the preceding. The ODT settings can be changed based on whether a memory device is a selected target of an access operation or a non-target device. ODT 746 settings can affect the timing and reflections of signaling on the terminated lines. Careful control over ODT 746 can enable higher-speed operation with improved matching of applied impedance and loading. ODT 746 can be applied to specific signal lines of I/O interface 742, 722 (for example, ODT for DQ lines or ODT for CA lines), and is not necessarily applied to all signal lines.

Memory device 740 includes controller 750, which represents control logic within the memory device to control internal operations within the memory device. For example, controller 750 decodes commands sent by memory controller 720 and generates internal operations to execute or satisfy the commands. Controller 750 can be referred to as an internal controller, and is separate from memory controller 720 of the host. Controller 750 can determine what mode is selected based on register 744, and configure the internal execution of operations for access to memory resources 760 or other operations based on the selected mode. Controller 750 generates control signals to control the routing of bits within memory device 740 to provide a proper interface for the selected mode and direct a command to the proper memory locations or addresses. Controller 750 includes command logic 752, which can decode command encoding received on command and address signal lines. Thus, command logic 752 can be or include a command decoder. With command logic 752, memory device can identify commands and generate internal operations to execute requested commands.

Referring again to memory controller 720, memory controller 720 includes command (CMD) logic 724, which represents logic or circuitry to generate commands to send to memory devices 740. The generation of the commands can refer to the command prior to scheduling, or the preparation of queued commands ready to be sent. Generally, the signaling in memory subsystems includes address information within or accompanying the command to indicate or select one or more memory locations where the memory devices should execute the command. In response to scheduling of transactions for memory device 740, memory controller 720 can issue commands via I/O 722 to cause memory device 740 to execute the commands. In one example, controller 750 of memory device 740 receives and decodes command and address information received via I/O 742 from memory controller 720. Based on the received command and address information, controller 750 can control the timing of operations of the logic and circuitry within memory device 740 to execute the commands. Controller 750 is responsible for compliance with standards or specifications within memory device 740, such as timing and signaling requirements. Memory controller 720 can implement compliance with standards or specifications by access scheduling and control.

Memory controller 720 includes scheduler 730, which represents logic or circuitry to generate and order transactions to send to memory device 740. From one perspective, the primary function of memory controller 720 could be said to schedule memory access and other transactions to memory device 740. Such scheduling can include generating the transactions themselves to implement the requests for data by processor 710 and to maintain integrity of the data (e.g., such as with commands related to refresh). Transactions can include one or more commands, and result in the transfer of commands or data or both over one or multiple timing cycles such as clock cycles or unit intervals. Transactions can be for access such as read or write or related commands or a combination, and other transactions can include memory management commands for configuration, settings, data integrity, or other commands or a combination.

Memory controller 720 typically includes logic such as scheduler 730 to allow selection and ordering of transactions to improve performance of system 700. Thus, memory controller 720 can select which of the outstanding transactions should be sent to memory device 740 in which order, which is typically achieved with logic much more complex that a simple first-in first-out algorithm. Memory controller 720 manages the transmission of the transactions to memory device 740, and manages the timing associated with the transaction. In one example, transactions have deterministic timing, which can be managed by memory controller 720 and used in determining how to schedule the transactions with scheduler 730.

In one example, memory controller 720 includes refresh (REF) logic 726. Refresh logic 726 can be used for memory resources that are volatile and need to be refreshed to retain a deterministic state. In one example, refresh logic 726 indicates a location for refresh, and a type of refresh to perform. Refresh logic 726 can trigger self-refresh within memory device 740, or execute external refreshes which can be referred to as auto refresh commands) by sending refresh commands, or a combination. In one example, controller 750 within memory device 740 includes refresh logic 754 to apply refresh within memory device 740. In one example, refresh logic 754 generates internal operations to perform refresh in accordance with an external refresh received from memory controller 720. Refresh logic 754 can determine if a refresh is directed to memory device 740, and what memory resources 760 to refresh in response to the command.

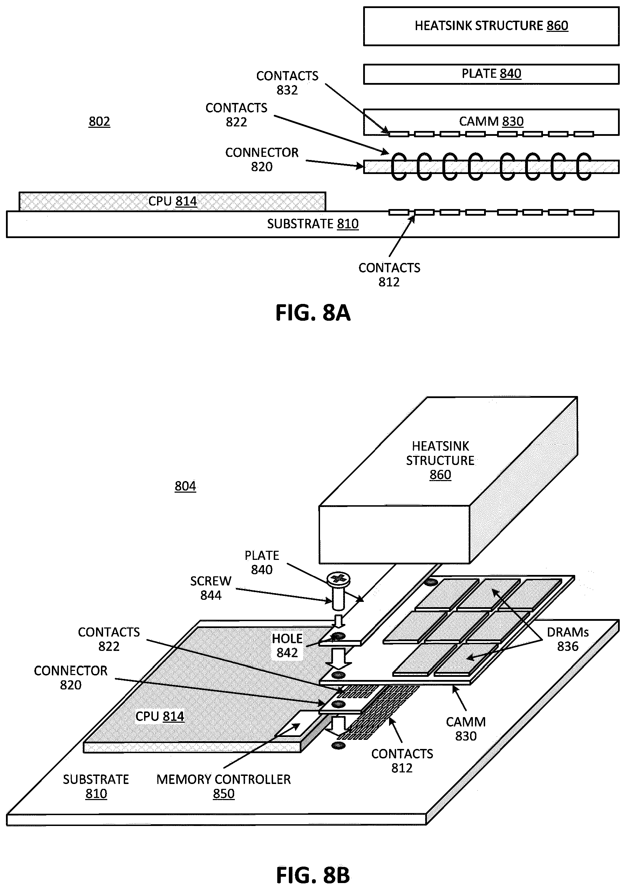

**Figures 8A-8B** are block diagrams of an example of a CAMM system in which a cooling system with a cooling bypass path can be implemented.

Referring to **Figure 8A**, system 802 includes a memory stack architecture monitored by a memory fault tracker that can perform mirroring. System 802 is an example of a system in accordance with an example of system 202, system 300, or system 402.

Substrate 810 illustrates an SOC package substrate or a motherboard or system board. Substrate 810 includes contacts 812, which represent contacts for connecting with memory. CPU 814 represents a processor or central processing unit (CPU) chip or graphics processing unit (GPU) chip to be disposed on substrate 810. CPU 814 performs the computational operations in system 802. In one example, CPU 814 includes multiple cores (not specifically shown), which can generate operations that request data to be read from and written to memory. CPU 814 can include a memory controller to manage access to the memory devices.

Compression-attached memory module (CAMM) 830 represents a module with memory devices, which are not specifically illustrated in system 802. Substrate 810 couples to CAMM 830 and its memory devices through compression mount technology (CMT) connector 820. Connector 820 includes contacts 822, which are compression-based contacts. The compression-based contacts are compressible pins or devices whose shape compresses with the application of pressure on connector 820. In one example, contacts 822 represent C-shaped pins as illustrated. In one example, contacts 822 represent another compressible pin shape, such as a spring-shape, an S-shape, or pins having other shapes that can be compressed.

CAMM 830 includes contacts 832 on a side of the CAMM board that interfaces with connector 820. Contacts 832 connect to memory devices on the CAMM board. Plate 840 represents a plate or housing that provides structure to apply pressure to compress contacts 822 of connector 820. In one example, system 802 includes heatsink structure 860 over CAMM 830. Heatsink structure 860 represents a cooling system structure to allow cooling fluid to bypass the processor device in accordance with any example herein.

Referring to **Figure 8B**, system 804 is a perspective view of a system in accordance with system 802. System 804 illustrates memory controller 850, which is not specifically illustrated in system 802. CAMM 830 is illustrated with memory chips or memory dies, identified as DRAMs 836 on one or both faces of the PCB of CAMM 830. DRAMs 836 are coupled with conductive contacts via conductive traces in or on the PCB, which couples with contacts 832, which in turn couple with contacts 822 of connector 820.

System 804 illustrates holes 842 in plate 840 to receive fasteners, represented by screws 844. There are corresponding holes through CAMM 830, connector 820, and in substrate 810. Screws 844 can compressibly attach the CAMM 830 to substrate 810 via connector 820. In one example, system 802 includes heatsink structure 860 over CAMM 830. Heatsink structure 860 represents a cooling system structure to allow cooling fluid to bypass the processor device in accordance with any example herein. It will be understood that different types of compression and different connectors, with and without plates, can be used for the CAMM modules.

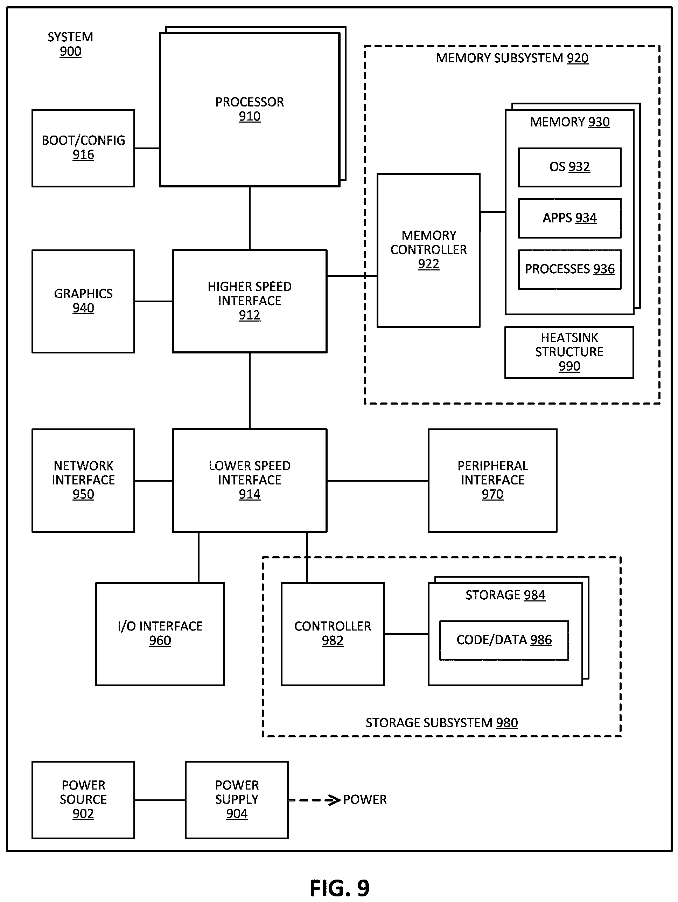

**Figure 9** is a block diagram of an example of a computing system in which a cooling system with a cooling bypass path can be implemented. System 900 represents a computing device in accordance with any example herein, and can be a laptop computer, a desktop computer, a tablet computer, a server, a gaming or entertainment control system, embedded computing device, or other electronic device.

System 900 is an example of a system in accordance with an example of system 202, system 300, or system 402. In one example, system 900 includes heatsink structure 990 over memory modules of memory 930. Heatsink structure 990 represents a cooling system structure to allow cooling fluid to bypass the processor device in accordance with any example herein.

System 900 includes processor 910 can include any type of microprocessor, central processing unit (CPU), graphics processing unit (GPU), processing core, or other processing hardware, or a combination, to provide processing or execution of instructions for system 900. Processor 910 can be a host processor device. Processor 910 controls the overall operation of system 900, and can be or include, one or more programmable general-purpose or special-purpose microprocessors, digital signal processors (DSPs), programmable controllers, application specific integrated circuits (ASICs), programmable logic devices (PLDs), or a combination of such devices. In one example, processor 910 is a multicore processor device.

System 900 includes boot/config 916, which represents storage to store boot code (e.g., basic input/output system (BIOS)), configuration settings, security hardware (e.g., trusted platform module (TPM)), or other system level hardware that operates outside of a host OS. Boot/config 916 can include a nonvolatile storage device, such as read-only memory (ROM), flash memory, or other memory devices.

In one example, system 900 includes interface 912 coupled to processor 910, which can represent a higher speed interface or a high throughput interface for system components that need higher bandwidth connections, such as memory subsystem 920 or graphics interface components 940. Interface 912 represents an interface circuit, which can be a standalone component or integrated onto a processor die. Interface 912 can be integrated as a circuit onto the processor die or integrated as a component on a system on a chip. Where present, graphics interface 940 interfaces to graphics components for providing a visual display to a user of system 900. Graphics interface 940 can be a standalone component or integrated onto the processor die or system on a chip. In one example, graphics interface 940 can drive a high definition (HD) display or ultra high definition (UHD) display that provides an output to a user. In one example, the display can include a touchscreen display. In one example, graphics interface 940 generates a display based on data stored in memory 930 or based on operations executed by processor 910 or both.

Memory subsystem 920 represents the main memory of system 900, and provides storage for code to be executed by processor 910, or data values to be used in executing a routine. Memory subsystem 920 can include one or more varieties of random-access memory (RAM) such as DRAM, 3DXP (three-dimensional crosspoint), or other memory devices, or a combination of such devices. Memory 930 stores and hosts, among other things, operating system (OS) 932 to provide a software platform for execution of instructions in system 900. Additionally, applications 934 can execute on the software platform of OS 932 from memory 930. Applications 934 represent programs that have their own operational logic to perform execution of one or more functions. Processes 936 represent agents or routines that provide auxiliary functions to OS 932 or one or more applications 934 or a combination. OS 932, applications 934, and processes 936 provide software logic to provide functions for system 900. In one example, memory subsystem 920 includes memory controller 922, which is a memory controller to generate and issue commands to memory 930. It will be understood that memory controller 922 could be a physical part of processor 910 or a physical part of interface 912. For example, memory controller 922 can be an integrated memory controller, integrated onto a circuit with processor 910, such as integrated onto the processor die or a system on a chip.

While not specifically illustrated, it will be understood that system 900 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect (PCI) bus, a HyperTransport or industry standard architecture (ISA) bus, a small computer system interface (SCSI) bus, a universal serial bus (USB), or other bus, or a combination.

In one example, system 900 includes interface 914, which can be coupled to interface 912. Interface 914 can be a lower speed interface than interface 912. In one example, interface 914 represents an interface circuit, which can include standalone components and integrated circuitry. In one example, multiple user interface components or peripheral components, or both, couple to interface 914. Network interface 950 provides system 900 the ability to communicate with remote devices (e.g., servers or other computing devices) over one or more networks. Network interface 950 can include an Ethernet adapter, wireless interconnection components, cellular network interconnection components, USB (universal serial bus), or other wired or wireless standards-based or proprietary interfaces. Network interface 950 represents a network interface circuit that can exchange data with a remote device over a network connection, which can include sending data stored in memory or receiving data to be stored in memory.

In one example, system 900 includes one or more input/output (I/O) interface(s) 960. I/O interface 960 can include one or more interface components through which a user interacts with system 900 (e.g., audio, alphanumeric, tactile/touch, or other interfacing). Peripheral interface 970 can include any hardware interface not specifically mentioned above. Peripherals refer generally to devices that connect dependently to system 900. A dependent connection is one where system 900 provides the software platform or hardware platform or both on which operation executes, and with which a user interacts.

In one example, system 900 includes storage subsystem 980 to store data in a nonvolatile manner. In one example, in certain system implementations, at least certain components of storage 980 can overlap with components of memory subsystem 920. Storage subsystem 980 includes storage device(s) 984, which can be or include any conventional medium for storing large amounts of data in a nonvolatile manner, such as one or more magnetic, solid state, NAND, 3DXP, or optical based disks, or a combination. Storage 984 holds code or instructions and data 986 in a persistent state (i.e., the value is retained despite interruption of power to system 900). Storage 984 can be generically considered to be a "memory," although memory 930 is typically the executing or operating memory to provide instructions to processor 910. Whereas storage 984 is nonvolatile, memory 930 can include volatile memory (i.e., the value or state of the data is indeterminate if power is interrupted to system 900). In one example, storage subsystem 980 includes controller 982 to interface with storage 984. In one example controller 982 is a physical part of interface 914 or processor 910, or can include circuits or logic in both processor 910 and interface 914.

Power source 902 provides power to the components of system 900. More specifically, power source 902 typically interfaces to one or multiple power supplies 904 in system 900 to provide power to the components of system 900. In one example, power supply 904 includes an AC to DC (alternating current to direct current) adapter to plug into a wall outlet. Such AC power can be renewable energy (e.g., solar power) power source 902. In one example, power source 902 includes a DC power source, such as an external AC to DC converter. In one example, power source 902 or power supply 904 includes wireless charging hardware to charge via proximity to a charging field. In one example, power source 902 can include an internal battery or fuel cell source.

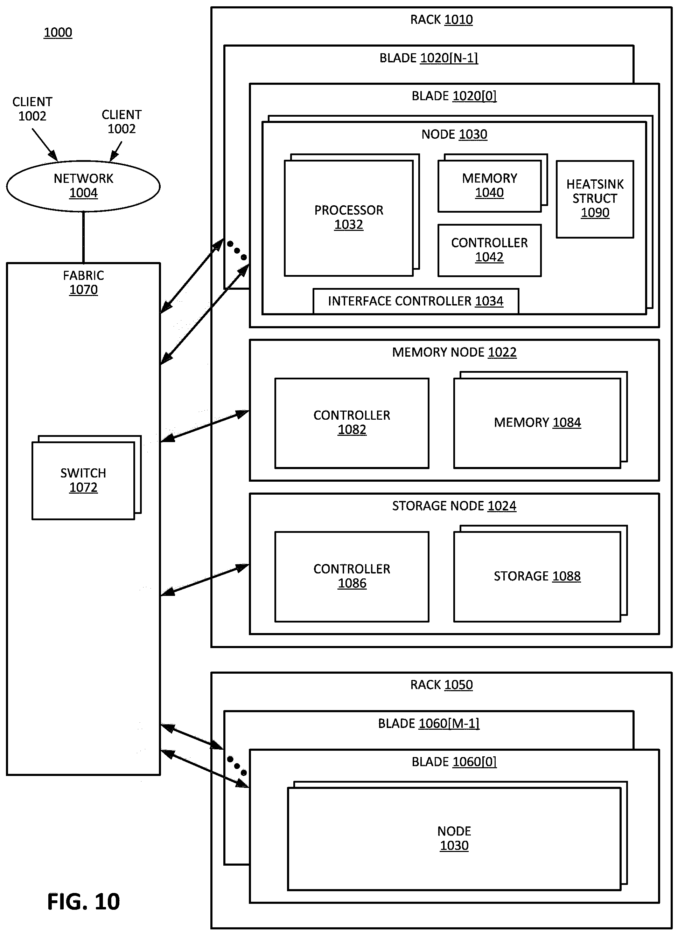

**Figure 10** is a block diagram of an example of a multi-node network in which a cooling system with a cooling bypass path can be implemented. In one example, system 1000 represents a data center. In one example, system 1000 represents a server farm. In one example, system 1000 represents a data cloud or a processing cloud.

Nodes 1030 of system 1000 represent a system in accordance with an example of system 202, system 300, or system 402. In one example, node 1030 includes heatsink structure 1090 over memory modules of memory 1040. Heatsink structure 1090 represents a cooling system structure to allow cooling fluid to bypass the processor device in accordance with any example herein.

One or more clients 1002 make requests over network 1004 to system 1000. Network 1004 represents one or more local networks, or wide area networks, or a combination. Clients 1002 can be human or machine clients, which generate requests for the execution of operations by system 1000. System 1000 executes applications or data computation tasks requested by clients 1002.

In one example, system 1000 includes one or more racks, which represent structural and interconnect resources to house and interconnect multiple computation nodes. In one example, rack 1010 includes multiple nodes 1030. In one example, rack 1010 hosts multiple blade components, blade 1020[0], ..., blade 1020[N-1], collectively blades 1020. Hosting refers to providing power, structural or mechanical support, and interconnection. Blades 1020 can refer to computing resources on printed circuit boards (PCBs), where a PCB houses the hardware components for one or more nodes 1030. In one example, blades 1020 do not include a chassis or housing or other "box" other than that provided by rack 1010. In one example, blades 1020 include housing with exposed connector to connect into rack 1010. In one example, system 1000 does not include rack 1010, and each blade 1020 includes a chassis or housing that can stack or otherwise reside in close proximity to other blades and allow interconnection of nodes 1030.

System 1000 includes fabric 1070, which represents one or more interconnectors for nodes 1030. In one example, fabric 1070 includes multiple switches 1072 or routers or other hardware to route signals among nodes 1030. Additionally, fabric 1070 can couple system 1000 to network 1004 for access by clients 1002. In addition to routing equipment, fabric 1070 can be considered to include the cables or ports or other hardware equipment to couple nodes 1030 together. In one example, fabric 1070 has one or more associated protocols to manage the routing of signals through system 1000. In one example, the protocol or protocols is at least partly dependent on the hardware equipment used in system 1000.

As illustrated, rack 1010 includes N blades 1020. In one example, in addition to rack 1010, system 1000 includes rack 1050. As illustrated, rack 1050 includes M blade components, blade 1060[0], ..., blade 1060[M-1], collectively blades 1060. M is not necessarily the same as N; thus, it will be understood that various different hardware equipment components could be used, and coupled together into system 1000 over fabric 1070. Blades 1060 can be the same or similar to blades 1020. Nodes 1030 can be any type of node and are not necessarily all the same type of node. System 1000 is not limited to being homogenous, nor is it limited to not being homogenous.

The nodes in system 1000 can include compute nodes, memory nodes, storage nodes, accelerator nodes, or other nodes. Rack 1010 is represented with memory node 1022 and storage node 1024, which represent shared system memory resources, and shared persistent storage, respectively. One or more nodes of rack 1050 can be a memory node or a storage node.

Nodes 1030 represent examples of compute nodes. For simplicity, only the compute node in blade 1020[0] is illustrated in detail. However, other nodes in system 1000 can be the same or similar. At least some nodes 1030 are computation nodes, with processor (proc) 1032 and memory 1040. A computation node refers to a node with processing resources (e.g., one or more processors) that executes an operating system and can receive and process one or more tasks. In one example, at least some nodes 1030 are server nodes with a server as processing resources represented by processor 1032 and memory 1040.

Memory node 1022 represents an example of a memory node, with system memory external to the compute nodes. Memory nodes can include controller 1082, which represents a processor on the node to manage access to the memory. The memory nodes include memory 1084 as memory resources to be shared among multiple compute nodes.

Storage node 1024 represents an example of a storage server, which refers to a node with more storage resources than a computation node, and rather than having processors for the execution of tasks, a storage server includes processing resources to manage access to the storage nodes within the storage server. Storage nodes can include controller 1086 to manage access to the storage 1088 of the storage node.

In one example, node 1030 includes interface controller 1034, which represents logic to control access by node 1030 to fabric 1070. The logic can include hardware resources to interconnect to the physical interconnection hardware. The logic can include software or firmware logic to manage the interconnection. In one example, interface controller 1034 is or includes a host fabric interface, which can be a fabric interface in accordance with any example described herein. The interface controllers for memory node 1022 and storage node 1024 are not explicitly shown.

Processor 1032 can include one or more separate processors. Each separate processor can include a single processing unit, a multicore processing unit, or a combination. The processing unit can be a primary processor such as a CPU (central processing unit), a peripheral processor such as a GPU (graphics processing unit), or a combination. Memory 1040 can be or include memory devices represented by memory 1040 and a memory controller represented by controller 1042.

In general with respect to the descriptions herein, in one aspect, a cooling system includes: a heatsink for a processor device; heatsinks for memory modules surrounding the processor device, including a heatsink over a downstream memory module that is downstream with respect to the processor device, with respect to a direction of a flow of a cooling fluid to cool the processor and the memory modules; and a fluid bypass to direct cooling fluid to the downstream memory module, wherein cooling fluid passing through the fluid bypass is directed to the downstream memory module without first being used to cool the processor device.

In one example of the cooling system, the fluid comprises air. In one example of the cooling system, the fluid comprises liquid. In accordance with any preceding example of the cooling system, in one example, the heatsinks for the memory modules comprise heatsinks of gradually increasing height in the downstream direction. In accordance with any preceding example of the cooling system, in one example, the heatsinks comprise a bidirectional heatsink over the downstream memory module. In accordance with any preceding example of the cooling system, in one example, the bidirectional heatsink comprises a series of slotted fins. In accordance with any preceding example of the cooling system, in one example, the bidirectional heatsink comprises a series of alternating, orthogonally stacked fins. In accordance with any preceding example of the cooling system, in one example, the bidirectional heatsink comprises pin fins. In accordance with any preceding example of the cooling system, in one example, the bidirectional heatsink comprises an amorphous solid material. In accordance with any preceding example of the cooling system, in one example, the memory modules comprise an upstream memory module that is upstream with respect to the processor device, with respect to the direction of the flow of the cooling fluid, wherein the upstream memory module has no heatsink. In accordance with any preceding example of the cooling system, in one example, the memory modules comprise side memory modules that are to a side of the processor with respect to the flow of the cooling fluid, and wherein the fluid bypass comprises ducting over the side memory modules to direct the cooling fluid over the side memory modules and redirect the cooling fluid to the downstream memory module. In accordance with any preceding example of the cooling system, in one example, the ducting comprises primary chamber to direct the cooling fluid over the side memory modules and a bypass chamber to bypass the side memory modules, wherein the ducting is to mix cooling fluid from the primary chamber and the bypass chamber to direct to the downstream memory module. In accordance with any preceding example of the cooling system, in one example, the ducting comprises primary chamber to direct the cooling fluid over the side memory modules and a bypass chamber to bypass the side memory modules, wherein the ducting is to direct cooling fluid from the primary chamber out the ducting, without passing to the downstream memory module, and to direct cooling fluid from the bypass chamber to the downstream memory module. In accordance with any preceding example of the cooling system, in one example, the ducting over the side memory modules comprises staggered vertical fins to direct the cooling fluid to the downstream memory module. In accordance with any preceding example of the cooling system, in one example, the ducting over the side memory modules comprises baffles to direct the cooling fluid to the downstream memory module. In accordance with any preceding example of the cooling system, in one example, the ducting over the side memory modules comprises curved vertical fins to direct the cooling fluid to the downstream memory module. In accordance with any preceding example of the cooling system, in one example, the heatsink for the processor device comprises a bypass mechanism to direct cooling fluid used to cool the processor device over the heatsink over the downstream memory module.

In general with respect to the descriptions herein, in one aspect, a computer system includes: a processor device; memory modules surrounding the processor device, including a downstream memory module that is downstream with respect to the processor device, with respect to a direction of a flow of cooling fluid to cool the processor and the memory modules; and a fluid bypass to direct cooling fluid to the downstream memory module, wherein cooling fluid passing through the fluid bypass is directed to the downstream memory module without first being used to cool the processor device.

In one example of the computer system, the fluid comprises air. In one example of the computer system, the fluid comprises liquid. In accordance with any preceding example of the computer system, in one example, the heatsinks for the memory modules comprise heatsinks of gradually increasing height in the downstream direction. In accordance with any preceding example of the computer system, in one example, the heatsinks comprise a bidirectional heatsink over the downstream memory module. In accordance with any preceding example of the computer system, in one example, the bidirectional heatsink comprises a series of slotted fins. In accordance with any preceding example of the computer system, in one example, the bidirectional heatsink comprises a series of alternating, orthogonally stacked fins. In accordance with any preceding example of the computer system, in one example, the bidirectional heatsink comprises pin fins. In accordance with any preceding example of the computer system, in one example, the bidirectional heatsink comprises an amorphous solid material. In accordance with any preceding example of the computer system, in one example, the memory modules comprise an upstream memory module that is upstream with respect to the processor device, with respect to the direction of the flow of the cooling fluid, wherein the upstream memory module has no heatsink. In accordance with any preceding example of the computer system, in one example, the memory modules comprise side memory modules that are to a side of the processor with respect to the flow of the cooling fluid, and wherein the fluid bypass comprises ducting over the side memory modules to direct the cooling fluid over the side memory modules and redirect the cooling fluid to the downstream memory module. In accordance with any preceding example of the computer system, in one example, the ducting comprises primary chamber to direct the cooling fluid over the side memory modules and a bypass chamber to bypass the side memory modules, wherein the ducting is to mix cooling fluid from the primary chamber and the bypass chamber to direct to the downstream memory module. In accordance with any preceding example of the computer system, in one example, the ducting comprises primary chamber to direct the cooling fluid over the side memory modules and a bypass chamber to bypass the side memory modules, wherein the ducting is to direct cooling fluid from the primary chamber out the ducting, without passing to the downstream memory module, and to direct cooling fluid from the bypass chamber to the downstream memory module. In accordance with any preceding example of the computer system, in one example, the ducting over the side memory modules comprises staggered vertical fins to direct the cooling fluid to the downstream memory module. In accordance with any preceding example of the computer system, in one example, the ducting over the side memory modules comprises baffles to direct the cooling fluid to the downstream memory module. In accordance with any preceding example of the computer system, in one example, the ducting over the side memory modules comprises curved vertical fins to direct the cooling fluid to the downstream memory module. In accordance with any preceding example of the computer system, in one example, the heatsink for the processor device comprises a bypass mechanism to direct cooling fluid used to cool the processor device over the heatsink over the downstream memory module. In accordance with any preceding example of the computer system, in one example, the processor device comprises a multicore processor device coupled to a memory controller. In accordance with any preceding example of the computer system, in one example, the computer system includes a display communicatively coupled to the processor device. In accordance with any preceding example of the computer system, in one example, the computer system includes a battery to power the system. In accordance with any preceding example of the computer system, in one example, the computer system includes a network interface circuit to couple with a remote device over a network connection.

Flow diagrams as illustrated herein provide examples of sequences of various process actions. The flow diagrams can indicate operations to be executed by a software or firmware routine, as well as physical operations. A flow diagram can illustrate an example of the implementation of states of a finite state machine (FSM), which can be implemented in hardware and/or software. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted; thus, not all implementations will perform all actions.

To the extent various operations or functions are described herein, they can be described or defined as software code, instructions, configuration, and/or data. The content can be directly executable ("object" or "executable" form), source code, or difference code ("delta" or "patch" code). The software content of what is described herein can be provided via an article of manufacture with the content stored thereon, or via a method of operating a communication interface to send data via the communication interface. A machine readable storage medium can cause a machine to perform the functions or operations described, and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

## Claims

1. A cooling system for a computing device, comprising:
a heatsink for a processor device;
heatsinks for memory modules surrounding the processor device, including a heatsink over a downstream memory module that is downstream with respect to the processor device, with respect to a direction of a flow of a cooling fluid to cool the processor and the memory modules; and
a fluid bypass to direct cooling fluid to the downstream memory module, wherein cooling fluid passing through the fluid bypass is directed to the downstream memory module without first being used to cool the processor device.

2. The cooling system of claim 1, wherein the heatsinks comprise a bidirectional heatsink over the downstream memory module.

3. The cooling system of claim 2, wherein the bidirectional heatsink comprises a series of slotted fins.

4. The cooling system of claim 2, wherein the bidirectional heatsink comprises pin fins.

5. The cooling system of claim 2, wherein the bidirectional heatsink comprises a series of alternating, orthogonally stacked fins.

6. The cooling system of claim 2, wherein the bidirectional heatsink comprises an amorphous solid material.

7. The cooling system of any of claims 1 to 6, wherein the memory modules comprise side memory modules that are to a side of the processor with respect to the flow of the cooling fluid, and wherein the fluid bypass comprises ducting over the side memory modules to direct the cooling fluid over the side memory modules and redirect the cooling fluid to the downstream memory module.

8. The cooling system of claim 7, wherein the ducting comprises primary chamber to direct the cooling fluid over the side memory modules and a bypass chamber to bypass the side memory modules, wherein the ducting is to mix cooling fluid from the primary chamber and the bypass chamber to direct to the downstream memory module.

9. The cooling system of claim 7, wherein the ducting comprises primary chamber to direct the cooling fluid over the side memory modules and a bypass chamber to bypass the side memory modules, wherein the ducting is to direct cooling fluid from the primary chamber out the ducting, without passing to the downstream memory module, and to direct cooling fluid from the bypass chamber to the downstream memory module.

10. The cooling system of claim 7, wherein the ducting over the side memory modules comprises staggered vertical fins to direct the cooling fluid to the downstream memory module, or alternatively, comprises baffles to direct the cooling fluid to the downstream memory module, or alternatively, comprises curved vertical fins to direct the cooling fluid to the downstream memory module.

11. The cooling system of any of claims 1 to 10, wherein the fluid comprises air.

12. The cooling system of any of claims 1 to 11, wherein the heatsinks for the memory modules comprise heatsinks of gradually increasing height in the downstream direction.

13. The cooling system of any of claims 1 to 12, wherein the memory modules comprise an upstream memory module that is upstream with respect to the processor device, with respect to the direction of the flow of the cooling fluid, wherein the upstream memory module has no heatsink.

14. The cooling system of any of claims 1 to 13, wherein the heatsink for the processor device comprises a bypass mechanism to direct cooling fluid used to cool the processor device over the heatsink over the downstream memory module.
